**Europäisches Patentamt**

**European Patent Office**

**Office européen des brevets**

(19)

(11) Veröffentlichungsnummer: **0 049 445**
**B1**

(12) **EUROPÄISCHE PATENTSCHRIFT**

(45) Veröffentlichungstag der Patentschrift:
**07.01.87**

(21) Anmeldenummer: **81107671.0**

(22) Anmeldetag: **26.09.81**

(51) Int. Cl.⁴: **H 01 L 29/74, H 01 L 29/743**

(54) **Selbstzündender Thyristor.**

(30) Priorität: **08.10.80 SE 8007036**

(43) Veröffentlichungstag der Anmeldung:
**14.04.82 Patentblatt 82/15**

(45) Bekanntmachung des Hinweises auf die Patenterteilung:
**07.01.87 Patentblatt 87/2**

(84) Benannte Vertragsstaaten:
**DE FR GB IT NL**

(56) Entgegenhaltungen:
**DE - A - 2 447 621**
**DE - A - 2 932 152**
**FR - A - 2 412 169**
**US - A - 3 524 114**

(73) Patentinhaber: **ASEA AB, S-721 83 Västeras (SE)**

(72) Erfinder: **Jonsson, Per-Erik, Dipl. Ing., Brälunden 8,
S-161 41 Bromma (SE)**
Erfinder: **Svedberg, Per, Dipl. Ing., Björnskogsgränd 13,
S-162 46 Vällinby (SE)**

(74) Vertreter: **Boecker, Joachim, Dr.-Ing.,
Rathenauplatz 2-8, D-6000 Frankfurt a.M. 1 (DE)**

## Beschreibung

Die Erfindung betrifft einen selbstzündenden Thyristor gemäss dem Oberbegriff des Anspruches 1. Ein solcher Thyristor ist bekannt aus der DE-OS 2 932 152, in der die Verwendung eines solchen Thyristors als Überspannungsschutz für elektronische Schaltkreise beschrieben wird.

Der Thyristor wird normalerweise durch Selbstzündung und nicht mit Hilfe eines Steuersignals gezündet. Der Thyristor ist also dafür vorgesehen und so beschaffen, dass er in den leitenden Zustand übergeht, wenn seine positive Sperrspannung einen bestimmten Wert, die Kippspannung des Thyristors, überschreitet.

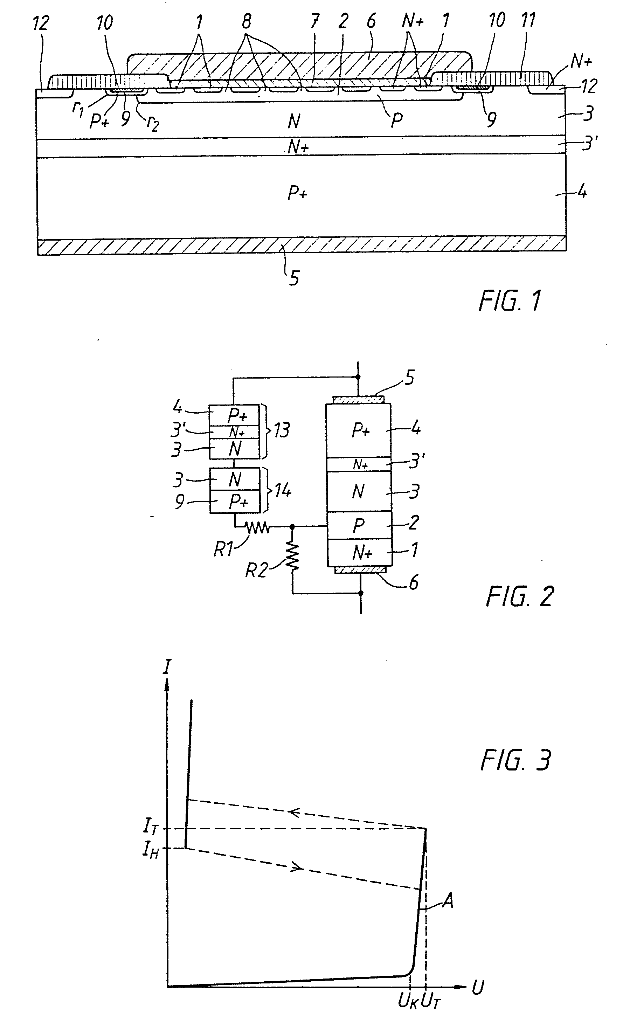

Figur 1 zeigt einen Thyristor dieser bekannten Art, Figur 2 zeigt schematisch den Thyristor und die mit ihm integrierte Zenerdiode, und Figur 3 zeigt die Strom-Spannungs-Kennlinie des Thyristors. Der Thyristor hat eine erste Emitterschicht 1, zwei Basisschichten 2 und 3 und eine zweite Emitterschicht 4. Die Emitterschichten sind stärker dotiert als die Basisschichten. Um den Injektionswirkungsgrad am Anoden-Emitterübergang zu verringern, ist eine hochdotierte N-leitende Schicht 3' in der Basisschicht 3 unmittelbar an der Emitterschicht 4 angeordnet. Die Störstellenkonzentration in dem Teil der Schicht 3', der unmittelbar an der Emitterschicht 4 liegt, ist zweckmässigerweise von gleicher Grössenordnung wie die Störstellenkonzentration in dem unmittelbar an der Schicht 3' angrenzenden Teil der Schicht 4. Die Schicht 1 ist mit einem Kathodenkontakt 6 und die Schicht 4 mit einem Anodenkontakt 5 versehen. Um zwischen dem Kontakt 6 und der Schicht 1 einen niedrigen Kontaktwiderstand zu bekommen, ist unmittelbar am Kontakt 6 eine Schicht 7 aus Platinsilizid angebracht. Die Kontakte 5 und 6 bestehen aus Metallschichten, z.B. Goldschichten. Eventuell kann auch unter dem Kontakt 5 eine Platinsilizidschicht angebracht werden, um den Kontaktwiderstand zu verringern. Die Schicht 1 ist mit über ihrer Fläche verteilten Kurzschlusslöchern 8 versehen, durch welche die Basisschicht 2 zu dem Kathodenkontakt 6, 7 hinaufreicht. Eine dünne $P^+$ – leitende Schicht 9 ist am Rande der Basisschicht 2 aufgebracht. Diese verläuft vorzugsweise um den ganzen Rand der Basisschicht herum und umgibt somit die Emitterschicht 1. Die Schicht 9 bildet zusammen mit der Schicht 3 eine Zenerdiode, die bei positiver Anoden-Kathodenspannung am Thyristor Sperrspannung erhält. Die Durchbruchspannung (Knickspannung) der Zenerdiode wird einerseits von der Störstellenkonzentration der Schicht 9 und andererseits vom Krümmungsradius $r_1$ des Randes der Schicht 9 bestimmt (siehe Fig. 1). Der Krümmungsradius beeinflusst die Feldgeometrie am Rande der Schicht und bestimmt somit, wie gross bei einer bestimmten am Thyristor leigenden Spannung die höchste auftretende Feldstärke wird. Durch geeignete Wahl der Störstellenkonzentration der Schicht 9 und des Krümmungsradius $r_1$ am Rande der Schicht 9 kann man erreichen, dass die Durchbruchspannung einen gewünschten Wert annimmt. Um sicherzustellen, dass der Durchbruch über die Zenerdiode und nicht im Thyristor stattfindet, ist die Schicht 9 vorzugsweise stärker dotiert als die der Schicht 2, und der Krümmungsradius $r_1$ am Rande der Schicht 9 ist vorzugsweise kleiner als der Krümmungsradius $r_2$ am Rand der Schicht 2.

Eine Schicht 10 aus Platinsilizid ergibt eine niederohmige ohmsche Verbindung in seitlicher Richtung der Znerdiode zur Basisschicht 2 des Thyristors. Die Oberfläche des Thyristors ist mit einer Siliziumdioxydschicht 11 bedeckt. Eine ringförmige Schutzschicht 12, die kräftiger N-dotiert ist, läuft um den Rand der Anordnung herum und verhindert Oberflächenstreuströme. Figur 2 zeigt schematisch den Aufbau des Thyristors aus den Schichten 1–4 und den Kontakten 5 und 6. Eine bei positiver Anodenspannung leitende Schicht 13 besteht aus den Schichten 4, 3' und 3 und liegt in Reihe mit der aus den Schichten 3 und 9 gebildeten Zenerdiode 13. Der Widerstand R1 in Figur 2 besteht aus dem lateralen Widerstand der Schicht 10 sowie der Schicht 2 bis zum Rande der Emitterschicht 1. Der Widerstand R2 in Figur 2 besteht aus dem lateralen Widerstand der Schicht 2 vom Rande der Schicht 1 bis zum nächsten Kurzschlussloch 8.

Wenn die am Thyristor liegende Spannung am Kontakt 5 positiv ist und die Knickspannung der Zenerdiode übersteigt, so fliesst Strom durch die Dioden 13 und 14 und die Widerstände R1 und R2 zur Kathode des Thyristors. Wenn der Spannungsfall am Widerstand R2 so gross wird, dass er den Durchlassspannungsfall (ca. 0,5–1 V) am Übergang zwischen den Schichten 1 und 2 erreicht, dann beginnt die Emitterschicht 1, an ihrem unmittelbar an der Zenerdiode liegenden Rand Elektronen zu injizieren, und die Zündung breitet sich dabei schnell über die Thyristoroberfläche aus.

Figur 3 zeigt die Strom-Spannungskennlinie des Thyristors, wobei $U_K$ die Knickpsannung der Zenerdiode, $U_T$ die Zündspannung des Thyristors, $I_T$ der Zündstrom des Thyristors und $I_H$ der Haltestrom des Thyristors ist.

Der Haltestrom des Thyristors wird so hoch gewählt, dass er über dem Strom liegt, den eine normale Leitungsspannung durch den Thyristor treiben kann. Der Thyristor erlischt daher, sobald die Überspannung verschwunden ist. Die Grösse des Haltestroms kann u.a. durch geeignete Wahl der Anzahl Kurzschlusslöcher pro Oberflächeneinheit eingestellt werden.

Je steiler der Kurvenabschnitt A in Figur 3 ist, d.h. je niedriger der dynamische Widerstand der Zenerdiode ist, desto exakter ist die Kippspannung des Thyristors definiert. Beispielsweise bei der Verwendung des Thyristors als Überspannungsschutz ist es von grosser Bedeutung, dass die Kippspannung so exakt wie möglich definiert ist.

In gewissen Fällen ist es wünschenswert, dass die Kippspannung des Thyristors steuerbar ist, z.B. zwischen zwei Werten umschaltbar ist oder kontinuierlich veränderbar ist. Wird der Thyristor beispielsweise als Überspannungsschutz benutzt, so können verschiedene Schutzniveaus bei verschiedenen Betriebszuständen einer zu schützenden Anordnung erforderlich sein. Durch Umschaltung oder Steuerung der Kippspannung in Abhängigkeit des Betriebszustandes der zu schützenden Anordnung lässt sich erreichen, dass das Schutzniveau stets den vorliegenden Erfordernissen angepasst ist.

Bei kleinem Nennstrom wird der Halbleiterkörper des Thyristors klein; er besteht dann beispielsweise aus einer quadratischen Scheibe mit einer Seitenlänge von einigen mm. Die Kapselung wird dabei oftmals dadurch vorgenommen, dass die Scheibe zwischen zwei Kontaktstiften innerhalb einer Kapsel auf solche Weise angebracht wird, dass die Endflächen der Stifte jeweils mit einer der beiden Endflächen der Scheibe Kontakt bilden. Dabei ist es wichtig, dass die Kontaktfläche der Scheibe (z.B. die Oberfläche des Kontaktes 6 in Figur 1) so gross wie möglich wird. Ferner kann bei der Kapselung eine mässige Schrägstellung des einen Kontaktstiftes zur Folge haben, dass seine Endfläche sowohl mit dem einen Hauptkontakt (z.B. 6 in Fig. 1) des Thyristors wie auch mit dem Rand der Scheibe Kontakt bildet, was bedeutet, dass der Halbleiterkörper funktionsunfähig wird.

Bei dem in Figur 1 gezeigten Thyristor besteht die nicht zu übersehende Gefahr, dass bei der Kapselung, die oft bei einer relativ hohen Temperatur vorgenommen werden muss, Atome unerwünschter Elemente, wie z.B. Eisen oder Kupfer von den Kontaktstiften, durch die Passivierungssicht 11 in den Halbleiterkörper eindringen und eine unerwünschte Verkürzung der Lebensdauer der Minoritätsladungsträger sowie eine unkontrollierte Beeinflussung der Kippspannung des Thyristors zur Folge haben.

Der Erfindung liegt die Aufgabe zugrunde, einen selbstzündenden Thyristor der eingangs genannten Art zu entwickeln, bei dem die integrierte Zenerdiode einen möglichst niedrigen dynamischen Widerstand hat. Ferner soll die Kippspannung des Thyristors variierbar sein. Die Halbleiterscheibe soll eine möglichst grosse Kontaktfläche haben, und die Gefahr eines Kontaktes zwischen einem Kontaktstift und dem Rand der Scheibe soll beseitigt sein. Ferner soll der Thyristor möglichst frei von eingedrungenen unerwünschten Störatomen sein und seine Kippspannung soll von solchen Störatomen möglichst unabhängig sein.

Zur Lösung dieser Aufgabe wird ein Thyristor nach dem Oberbegriff des Anspruches 1 vorgeschlagen, der erfindungsgemäss die im kennzeichnenden Teil des Anspruches 1 genannten Merkmale hat.

Vorteilhafte Weiterbildungen der Erfindung sind in den Unteransprüchen genannt.

Anhand der Figuren soll die Erfindung näher erläutert werden. Es zeigen

Fig. 1 den Aufbau eines bekannten Thyristors,

Fig. 2 ein schematisches Bild des Thyristors gemäss Fig. 1,

Fig. 3 die Strom-Spannungs-Kennliene des Thyristors nach Fig. 1,

Fig. 4a–4d ein Ausführungsbeispiel eines Thyristors gemäss der Erfindung,

Fig. 5 eine weitere Ausführungsform eines Thyristors nach der Erfindung, bei welcher eine freistehende elektrisch leitende Schicht vorhanden ist,

Fig. 6 eine weitere Ausführungsform eines Thyristors gemäss der Erfindung, bei welcher die Kippspannung des Thyristors auf optischem Wege steuerbar ist.

Die Figuren 1–3 wurden bereits oben beschrieben.

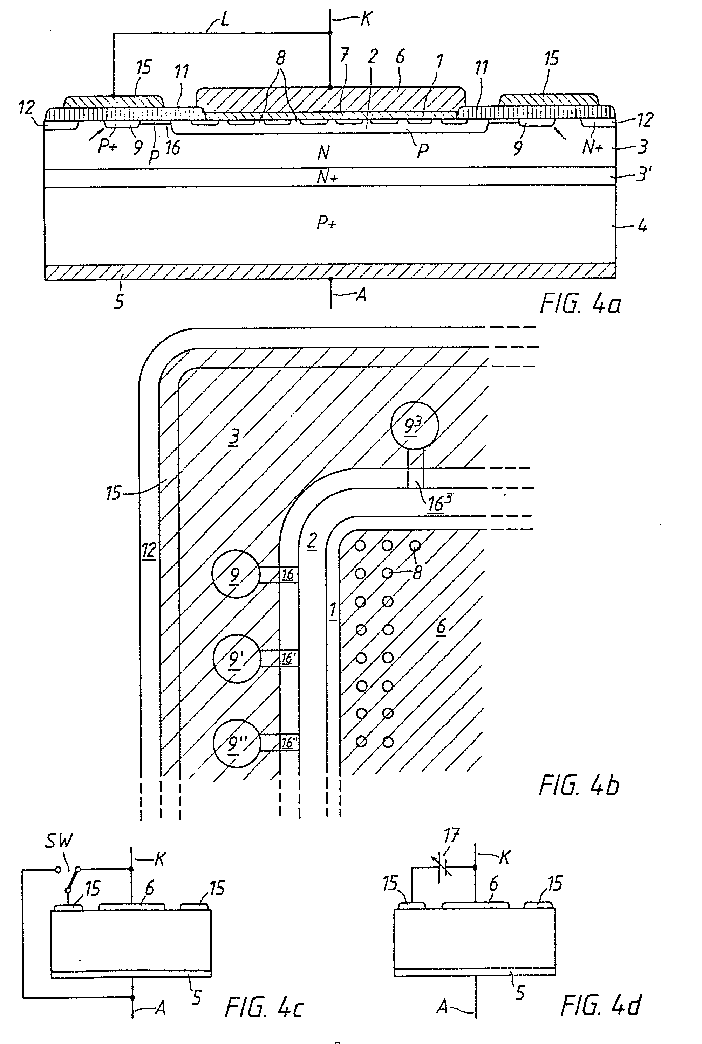

Figur 4a zeigt einen Schnitt durch einen Thyristor gemäss der Erfindung. Er hat im wesentlichen denselben Aufbau wie der in Figur 1 gezeigte Thyristor und ist mit denselben Bezugszeichen versehen. Der Thyristor hat einen schematisch gezeigten Anodenanschluss A und einen Kathodenanschluss K. Radial ausserhalb des Randes der P-Schicht 2 sind mehrere $P^+$-leitende Bereiche (9) vorhanden. Der Übergang zwischen jedem dieser Bereiche und der N-leitenden Schicht 3 ist ein Zenerübergang. Jeder dieser Bereiche ist mit der P-Schicht 2 über einen P-dotierten Bereich 16 verbunden. Auf der isolierenden Schicht 11 und über dem Teil des Zenerüberganges, in welchem der Durchbruch stattfindet, ist eine aus Metall bestehende Schicht 15 angeordnet.

Figur 4b zeigt einen Teil des Thyristors von oben (von der Kathodenseite) gesehen. Die Randlinien der Schichten 12, 3, 9, 16, 2, 1 wie auch die Kurzschlusslöcher 8 sind gekennzeichnet. In Figur 4b sind vier $P^+$-dotierte Bereiche 9, 9', 9'' und $9^3$ gezeigt, welche mit der Schicht 2 über die P-dotierten Bereiche 16, 16', 16'' und $16^3$ verbunden sind. Die Anzahl der Bereiche 9 und 16 ist dem Strom ($I_T$ in Figur 3) angepasst, welchen die Zenerübergänge insgesamt maximal zu führen im Stande sein sollen. Es kann sich hierbei um einige Hundert handeln. Die Schicht 15 und der Kontakt 6 sind als gestrichelte Flächen in Figur 4b dargestellt.

Die Schicht 15 kann an die Kathode 6 des Thyristors (siehe in Figur 4a den schematisch dargestellten Leiter L), an die Anode 5 des Thyristors oder an ein anderes festes oder variierbares Potential angeschlossen sein. Das Potential der Schicht beeinflusst die Feldgeometrie am Zenerübergang. Die Schicht bewirkt eine seitliche Ausbreitung der Sperrschicht, und der Teil des Zenerüberganges, an dem eine maximale Feldstärke auftritt, d.h. wo der Durchbruch stattfindet, ist in Figur 4a mit Pfeilen gekennzeichnet. Im allgemeinen tritt die maximale Feldstärke und damit der Durchbruch an dem Teil des Überganges auf, der gegenüber der Horizontalebene eine Neigung von ca. 45° hat. Das bedeutet, dass der Durchbruch relativ tief unter der Oberfläche des Halbleiterkörpers stattfindet.

Bei dem bekannten Thyristor nach Figur 1a hat es sich in der Praxis gezeigt, dass der Durchbruch dazu neigt, an dem unmittelbar an der Oberfläche liegenden Teil des Zenerübergangs stattzufinden.

Der Grund hierfür besteht wahrscheinlich darin, dass die nach der Eindiffundierung der Bereiche 9 stattfindenden Behandlungsschritte die Form des Überganges verändern, so dass unmittelbar unter der Oberfläche eine scharfe Kante entsteht. Hierdurch wird die Durchbruchspannung auf unkontrollierbare Weise gesenkt, und die Kippspannung des Thyristors wird niedriger und hat eine grössere Streuung. Ferner wird der kritische Teil des Überganges Verunreinigungen stärker ausgesetzt, die in den Halbleiterkörper von dessen Oberfläche aus eindiffundieren und die Durchbruchspannung beeinflussen.

Bei dem Thyristor nach der Erfindung erfolgt der Durchbruch im Zenerübergang aufgrund der Wirkung der Schicht 15 in einer erheblich grösseren Tiefe unter der Oberfläche des Halbleiterkörpers. Eventuelle Störungen in der Form des Überganges unmittelbar an der Oberfläche haben daher auf die Durchbruchspannung keinen Einfluss. Ferner wird der Gehalt an Verunreinigungen am kritischen Teil des Überganges, also an dem Teil, an dem der Durchbruch stattfindet, kleiner als an der Oberfläche. Ausserdem bildet die Schicht 15 einen zusätzlichen Schutz gegen Verunreinigungen, die, beispielsweise bei der Kapselung, in den Halbleiterkörper eindringen können. Aus diesen Gründen ist die Durchbruchspannung des Zenerüberganges und damit die Kippspannung des Thyristors wesentlich leichter vorauszubestimmen und zu beeinflussen. Durchbruchspannung und Kippspannung weisen geringere Streuungen auf als bei dem bekannten Thyristor. Der beim Durchbruch auftretende Stromfluss in der Schicht 3 liegt tiefer im Halbleiterkörper, also in Bereichen, in denen die Oberflächenrekombinationen und der Gehalt an Verunreinigungen, welche die Lebensdauer verkürzen, geringer ist. Dieser Strom, der aus von der Schicht 4 injizierten Ladungsträgern besteht, trägt dazu bei, den dynamischen Widerstand des Zenerdiodenteils zu verkleinern. Es hat sich gezeigt, dass dieser Widerstand bedeutend kleiner ist als bei dem bekannten Thyristor, so dass der Kurvenabschnitt A in Figur 3 steiler wird, was ein wichtiger Vorteil der Erfindung ist.

Es hat sich gezeigt, dass der dynamische Widerstand der Zenerdiode bei einem Thyristor nach der Erfindung in einem Teil der Kennlinie negativ werden kann, was wahrscheinlich darauf beruht, dass der Injektionswirkungsgrad stromabhängig ist. Diese Erscheinung könnte Instabilitäten und Schwingungstendenzen bewirken sowie die Strom-Spannungs-Kennlinie des Thyristors schwer definierbar machen. Gemäss einer bevorzugten Ausführungsform der Erfindung sind daher die Bereiche 9 von der Schicht 2 räumlich voneinander getrennt angeordnet und mit dieser Schicht über besondere Bereiche 16 verbunden. Die letztgenannten Bereiche fungieren als Reihenwiderstände für die Zenerdioden. Durch die Wahl zweckmässiger Werte für die Länge, Breite, Tiefe und Dotierung der Bereiche 16 können deren Widerstände derart bemessen werden, dass die erwähnten Instabilitäten und Schwingungstendenzen beseitigt werden. Es hat sich gezeigt, dass dies gemacht werden kann, ohne dass man auf den wichtigen Vorteil der Erfindung – den niedrigen dynamischen Widerstand – zu verzichten braucht.

Die Schicht 15 bietet neben den genannten Vorteilen auch die Möglichkeit, die Kippspannung des Thyristors zu steuern. Wie in Figur 4c gezeigt, kann ein Schalter SW vorgesehen sein, mit welchem die Schicht 15 wahlweise mit einem von 2 Potentialen verbunden werden kann. In dem gezeigten Fall handelt es sich bei diesen Potentialen um die Anoden- und Kathodenpotentiale des Thyristors. Wenn die Schicht 15 mit der Kathode 6 des Thyristors verbunden ist, erhält man einen höheren Wert für die Kippspannung, als wenn die Schicht 15 mit der Anode 5 verbunden ist. Der Schalter SW kann eine Transistorschaltung sein und eventuell mit dem Thyristor integriert sein oder in derselben Kapsel wie der Thyristor angeordnet sein.

Die Potentiale, an welche die Schicht 15 angeschlossen werden kann, kann man alternativ mit Hilfe ausserhalb der Thyristorkapsel angeordneter Spannungsquellen, beispielsweise mit Hilfe von zwischen Anode A und Kathode K des Thyristors angeordneten Spannungsteilern, erzeugen.

Figur 4d zeigt, wie die Schicht 15 an eine variierbare (alternativ konstante) Spannungsquelle 17 angeschlossen sein kann, die der Schicht 15 ein bestimmtes festes oder ein steuerbares Potential relativ zur Kathode K gibt. Hierdurch kann die Kippspannung des Thyristors auf den gewünschten Wert festgelegt oder kontinuierlich gesteuert werden.

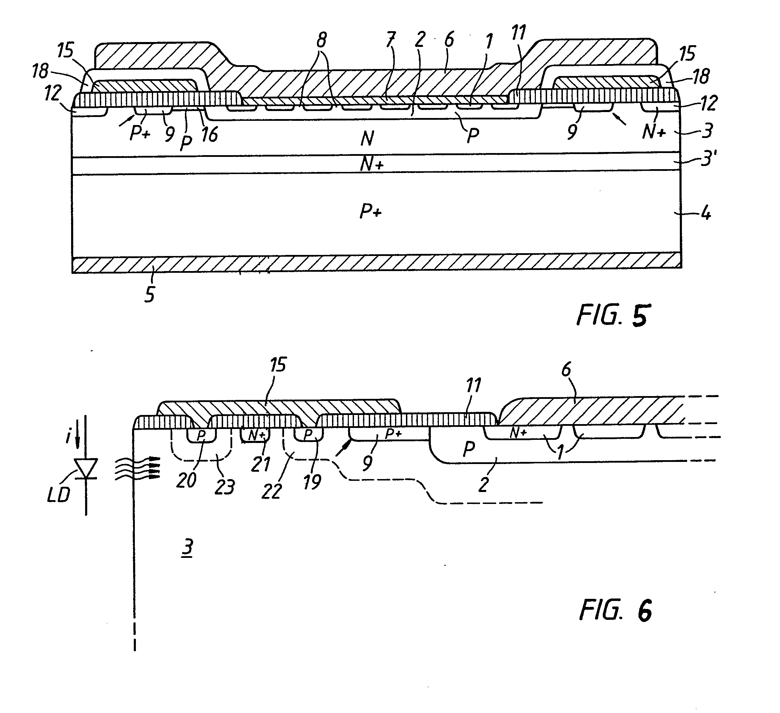

Figur 5 zeigt, wie man die genannten Vorteile auch mit einer Schicht erzielen kann, der nicht an Kathodenpotential angeschlossen ist. Eine isolierende Schicht 18, beispielsweise aus Siliziumdioxyd, ist über der Schicht 15 angebracht. Der Kathodenkontakt 6 ist dann in seitlicher Richtung verlängert und bedeckt die isolierende Schicht 18.

Figur 6 zeigt eine Ausführungsform des Thyristors, bei welcher die Kippspannung auf optischem Wege gesteuert werden kann. Nur ein Teil des Randabschnittes des Thyristors ist in der Figur gezeigt. In der Nähe des kritischen Teils (kenntlich gemacht durch den Einzelpfeil) des Zenerüberganges sind ein P-leitender Bereich 19, ein $N^+$-leitender Bereich 21 und ein P-leitender Bereich 20 aufgebracht. Die Schicht 15 steht über Öffnungen in der Isolationsschicht 11 in Kontakt mit den Bereichen 19 und 20. Bei Sperrungen am Thyristor entsteht eine Sperrschicht 22 am Übergang zwischen der Schicht 3 einerseits und den Schichten 2 und 9 andererseits. Der Bereich 19 und die Schicht 15 werden dann über die Streuströme an das Kathodenpotential geschaltet. Eine Sperrschicht 23 entsteht dann am Übergang zwischen der Schicht 3 und dem Bereich 20. Das Potential des Schirmes wird von dem Verhältnis zwischen dem Streustrom im Bereich 20 und dem Streustrom im Bereich 19 bestimmt. Zweckmässig wird die Anordnung so ausgebildet, dass der erstgenannte Streustrom klein im Verhältnis zu dem letztgenannten ist. Die Schicht 15 nimmt dann ein normales Potential an, das nahe dem Potential der Kathode liegt, und die Kippspannung des Thyristors wird hoch. Dadurch, dass ein Strom i durch eine Leuchtdiode LD getrieben wird, sendet diese Licht aus. Die Leuchtdiode ist so angeordnet, dass das Licht auf die Sperrschicht 23 fällt. Das Licht erzeugt Ladungsträger in der Sperrschicht, und der Streustrom wird grösser, wobei das Potential der Schicht 15 grösser wird. Je grösser die Beleuchtungsintensität ist, desto näher liegt das Potential der Schicht am Potential der Anode, und desto niedriger ist die Kippspannung des Thyristors.

Die Schicht 21 trennt die Sperrschicht 23 von der Sperrschicht 22.

Die Leuchtdiode LD kann innerhalb oder ausserhalb der Kapsel angeordnet sein, in der der Thyristor untergebracht ist.

Bei den Ausführungsformen nach den Figuren 4 und 6 kann eine isolierende Schicht auf die Schicht 15 angebracht werden, um die Gefahr zu beseitigen, dass die Schicht 15 bei der Anbringung der Kontaktkörper des Thyristors in elektrischem Kontakt mit dem Kathodenkontaktkörper gelangt.

In den Figuren ist die Dicke der Bauteile im Verhältnis zu ihrer Breite stark übertrieben dargestellt.

## Patentansprüche

1. Selbstzündender Thyristor (1–6) mit einer Zenerdiode (3, 9), welche den die positive Sperrspannung aufnehmenden Übergang (2–3) des Thyristors überbrückt und die Kippspannung des Thyristors bestimmt, mit einer an einer Hauptfläche des Thyristors angeordneten Emitterschicht (1) des Thyristors, auf welcher Hauptfläche eine Kontaktschicht (6) angeordnet ist, einer neben der Emitterschicht (1) angeordneten Zenerdiode und einer die Zenerdiode überdeckenden elektrisch isolierenden Schicht (11), dadurch gekennzeichnet, dass eine separate, elektrisch leitende Schicht (15) auf der Oberfläche der elektrisch isolierenden Schicht (11) im Bereich der Zenerdiode angeordnet ist, und dass der Thyristor mit Mitteln versehen ist zur Beeinflussung des Potentials der elektrisch leitenden Schicht (15) und dadurch der Kippspannung des Thyristors.

2. Thyristor nach Anspruch 1, dadurch gekennzeichnet, dass Mittel (L, SW) zum wahlweisen Anschluss der separaten Schicht (15) an eine der Hauptelektroden (A, K) des Thyristors vorhanden ist.

3. Thyristor nach Anspruch 1, dadurch gekennzeichnet, dass die separate Schicht (15) an eine Spannungsquelle (17) angeschlossen ist, die ihr ein Potential vermittelt, das sich von dem Potential der Hauptelektroden (A, K) des Thyristors unterscheidet.

4. Thyristor nach Anspruch 1, dadurch gekennzeichnet, dass der Thyristor mit Mitteln (LD, 19, 20) zu optischen Steuerung des Potentials der separaten Schicht (15) versehen ist.

5. Thyristor nach einem der vorhergehenden Ansprüche, dadurch gekennzeichnet, dass die Zenerdiode (3, 9) des Thyristors räumlich getrennt von der einen Basisschicht (2) des Thyristors und seitlich dieser Basisschicht (2) angeordnet ist und über einen resistiven Bereich (16) mit dieser Basisschicht elektrisch verbunden ist.

6. Thyristor nach Anspruch 5, dadurch gekennzeichnet, dass das resistive Element (16) eine im Halbleiterkörper des Thyristors angebrachte Oberflächenschicht ist.

7. Thyristor nach Anspruch 6, dadurch gekennzeichnet, dass er mit mehreren voneinander getrennten Zenerdioden (3, 9; 3, 9', 3, 9'') integriert ist, von denen jede über ein resistives Element (16, 16', 16'') mit der genannten Basisschicht (2) verbunden ist.

## Claims

1. Self-ignitable thyristor (1–6) with a zener diode (3, 9) bridging the junction (2–3) of the thyristor across which junction the positive off-state voltage appears, and determining the breakover voltage of the thyristor, with an emitter layer (1) of the thyristor being located on one main surface of the thyristor, a contact layer (6) being arranged on said main surface, with a zener diode arranged adjacent said emitter layer (1), and with an electrically insulating layer (11) covering said zener diode, characterized in that a separate electrically conductive layer (15) ist arranged on the surface of said electrically insulating layer (11) in the area of the zener diode, and that the thyristor is provided with means to influence the potential of the electrically conductive layer (15) and thus influencing the breakover voltage of the thyristor.

2. Thyristor according to claim 1, characterized in that there are means (L, SW) for selectively connecting the separate layer (15) to one of the main electrode (A, K) of the thyristor.

3. Thyristor according to claim 1, characterized in that said separate layer (15) is connected to a voltage source (17) which delivers a potential different from the potential of the main electrodes (A, K) of the thyristor.

4. Thyristor according to claim 1, characterized in that the thyristor is provided with means (LD, 19, 20) for optical control of the potential of the separate layer (15).

5. Thyristor according to any of the preceding claims, characterized in that the zener diode (3, 9) of the thyristor is geometrically separated from one of the base layers (2) of the thyristor and is located laterally of said base layer (2) and is electrically connected to this base layer via the resistive area (16).

6. Thyristor according to claim 5, characterized in that the resistive element (16) consists of a surface layer arranged in the semiconductor body of the thyristor.

7. Thyristor according to claim 6, characterized in that it is integral with a plurality of zener diodes (3, 9; 3, 9'; 3, 9'') separated from each other, each zener diode being connected with said base layer (2) via a resistive element (16, 16', 16'').

**Revendications**

1. Thyristor à auto-amorçage (1–6), avec une diode Zener (3, 9) qui est en parallèle sur la jonction (2–3) du thyristor, qui reçoit la tension positive de blocage et qui détermine la tension directe de recouvrement du thyristor, avec une couche d'émetteur (1) du thyristor, qui est disposée sur une surface principale du thyristor sur laquelle est disposée une couche de contact (6), avec une diode Zener disposée près de la couche d'émetteur (1), et avec une couche électriquement isolante (11) qui recouvre la diode Zener, caractérisé par le fait qu'une couche distincte, électriquement conductrice, (15) est disposée sur la surface de la couche électriquement isolante (11), dans la zone de la diode Zener, et que le thyristor est pourvu de moyens pour influencer le potentiel de la couche électriquement conductrice (15) et, par voie de conséquence, la tension directe de recouvrement.

2. Thyristor selon la revendication 1, caractérisé par le fait que des moyens (L, SW) sont prévus pour relier, au choix, la couche distincte (15) à l'une des électrodes principales (A, K) du thyristor.

3. Thyristor selon la revendication 1, caractérisé par le fait que la couche distincte (15) est reliée à une source de tension (17) qui lui communique une tension qui est distincte du potentiel des électrodes principales (A, K) du thyristor.

4. Thyristor selon la revendication 1, caractérisé par le fait que le thyristor est pourvu de moyens (LD, 19, 20) pour commander par voie optique le potentiel de la couche distincte (15).

5. Thyristor selon l'une quelconque des revendications précédentes, caractérisé par le fait que la diode Zener (3, 9) du thyristor est spatialement séparée de la couche de base (2) du thyristor et est disposée latéralement par rapport à cette dernière, alors que par l'intermédiaire d'une zone résistive (16) elle este reliée électriquement à cette couche de base.

6. Thyristor selon la revendication 5, caractérisé par le fait que l'élément résistif (16) est une couche superficielle qui est disposée dans le corps semiconducteur du thyristor.

7. Thyristor selon la revendication 6, caractérisé par le fait qu'il est intégré avec plusieurs diodes Zener distinctes (3, 9; 3, 9', 3, 9'') parmi lesquelles chacune est reliée à ladite couche de base (2), par l'intermédiaire d'un élément résistif (16, 16', 16'').

FIG. 1

FIG. 2

FIG. 3

FIG. 4a

FIG. 4b

FIG. 4c

FIG. 4d

FIG. 5

FIG. 6